(19) Europäisches Patentamt
European Patent Office
Office européen des brevets

(11) **EP 1 012 965 B1**

(12) **EUROPÄISCHE PATENTSCHRIFT**

(45) Veröffentlichungstag und Bekanntmachung des Hinweises auf die Patenterteilung:
**06.11.2002 Patentblatt 2002/45**

(21) Anmeldenummer: **98951180.3**

(22) Anmeldetag: **20.08.1998**

(51) Int Cl.⁷: **H03C 3/09**, H03L 7/18

(86) Internationale Anmeldenummer:
**PCT/DE98/02437**

(87) Internationale Veröffentlichungsnummer:
**WO 99/014849 (25.03.1999 Gazette 1999/12)**

(54) **SCHALTUNG ZUM ERZEUGEN EINES MODULIERTEN SIGNALS**

CIRCUIT FOR PRODUCING A MODULATED SIGNAL

CIRCUIT POUR PRODUIRE UN SIGNAL MODULE

(84) Benannte Vertragsstaaten:
**DE FR GB**

(30) Priorität: **12.09.1997 DE 19740196**

(43) Veröffentlichungstag der Anmeldung:
**28.06.2000 Patentblatt 2000/26**

(73) Patentinhaber: **SIEMENS AKTIENGESELLSCHAFT**
**80333 München (DE)**

(72) Erfinder: **HOFMANN, Ludwig**
**D-85304 Ilmmünster (DE)**

(56) Entgegenhaltungen:
**EP-A- 0 527 660**          **DE-C- 4 320 087**
**US-A- 5 497 399**

**Beschreibung**

Die Erfindung betrifft eine Schaltung zum Erzeugen eines modulierten Signals. Insbesondere ist die Erfindung zum Erzeugen eines frequenz- und/oder phasenmodulierten Hochfrequenzsignals vorgesehen, wie es beispielsweise bei Funkübertragungsgeräten, schnurlosen Telefonen, Mobiltelefonen und sonstigen modulierenden Datenübertragungseinrichtungen benötigt wird.

Es ist bekannt, zum Erzeugen von frequenz- oder phasenmodulierten Signalen Quadraturmodulatoren zu verwenden, die entweder auf der Sendefrequenz arbeiten oder eine Zwischenfrequenzmodulation mit anschließender Umsetzung auf die Sendefrequenz verwenden. Mit derartigen Quadraturmodulatoren können frequenz- oder phasenmodulierte Signale mit hoher Frequenz- bzw. Phasengenauigkeit erzeugt werden. Solche hohen Anforderungen an die Genauigkeit werden beispielsweise bei dem im GSM-Standard verwendeten GMSK-Modulationsverfahren (Gauss minimum shift keying) oder bei dem DPSK-Modulationsverfahren (differential phase shift keying) gefordert.

Schaltungen mit Quadraturmodulatoren sind jedoch sowohl im Digitalteil als auch - vor allem - im Analogteil aufwendig, verlangen engtolerierte Bauelemente und sind schlecht integrierbar.

Aus der DE 43 20 087 C1 ist ein Steuergenerator mit einer Phasenregelschleife mit den Merkmalen des Oberbegriffs von Anspruch 1 bekannt. Als mögliche Ausgestaltung ist angegeben, daß der Generator über die Eingabe geeigneter Steuerworte auf digitalem Wege sowohl frequenz- als auch phasenmoduliert werden kann. Genauere Angaben im Zusammenhang mit den zur Modulation vorgesehenen Merkmalen sind jedoch nicht offenbart.

Es ist demgemäß Aufgabe der Erfindung, die genannten Probleme zu vermeiden und eine Schaltung zum Erzeugen eines modulierten Signals mit hoher Phasen- und Frequenzgenauigkeit bereitzustellen, die einen geringen Bauteilaufwand hat und insbesondere gut integrierbar ist sowie eine hohe Modulationsqualität zu erzielen vermag.

Erfindungsgemäß wird diese Aufgabe durch eine Schaltung mit den Merkmalen des Anspruchs 1 gelöst.

Die Erfindung geht von der Grundidee aus, eine reziproke Digitalsynthese-Einrichtung zum Erzeugen des modulierten Ausgangssignals zu verwenden. Bei der reziproken Digitalsynthese-Einrichtung wird mit Hilfe einer an sich bekannten Digitalsynthese-Schaltung (auch als DDS-Schaltung bezeichnet, wobei DDS für "direct digital sythesizing" steht) ein gesteuerter Oszillator an einen Referenzoszillator gebunden, wobei der gesteuerte Oszillator über eine Phasenvergleichsschaltung nachgezogen wird.

Die erfindungsgemäße Schaltung zum Erzeugen des modulierten Signals weist eine hohe Genauigkeit und spektrale Reinheit des Ausgangssignals auf. Trotz dieser hohen Qualität ist nur ein relativ geringer Bauteilaufwand erforderlich, und die Schaltung ist wegen des hohen digitalen Anteils gut integrierbar. Das Ausgangssignal kann in sehr kleinen Abstimmschritten moduliert werden. Dadurch, daß die Frequenz des Ausgangssignals extrem präzise eingestellt werden kann, ist auch eine gute und genaue Phasenmodulation möglich.

Bei der erfindungsgemäßen Schaltung ist eine Ansteuereinrichtung vorgesehen, die aus vorzugsweise digitalen Trägerfrequenz- und Modulationssignalen ein digitales Ansteuersignal für die Digitalsynthese-Schaltung erzeugt. Im hier verwendeten Sinne wird als ein digitales Signal jedes Signal oder Signalbündel verstanden, aus dem sich digitale Werte ableiten lassen. Insbesondere kann ein digitales Signal daher mehrere Teilsignale aufweisen, die auf je einer Leitung eines parallelen Datenübertragungsweges übertragen werden. Jedes Teilsignal definiert dann zu jedem Zeitpunkt ein Bit eines digitalen Datenworts.

In bevorzugten Ausführungsformen enthält die Ansteuereinrichtung einen Addierer, der das Ansteuersignal durch Addition der Trägerfrequenz- und Modulationssignale erzeugt. Dabei definieren die genannten Signale vorzugsweise je mindestens ein digitales Datenwort oder eine Folge digitaler Datenworte. Das Trägerfrequenzsignal gibt in bevorzugten Ausführungsformen die Trägerfrequenz für das modulierte Ausgangssignal an, während das Modulationssignal vorzugsweise eine Folge vorzeichenbehafteter digitaler Datenworte definiert, die eine Abweichung des modulierten Ausgangssignals von der Trägerfrequenz bestimmen.

Die Trägerfrequenz- und Modulationssignale sind vorzugsweise je ein Bündel parallel übertragener digitaler Teilsignale, die in zwei Zwischenspeichern (latches) der Ansteuereinrichtung zur Eingabe in den Addierer gespeichert werden.

Um eine gute Modulationsqualität zu erzielen, ist erfindungsgemäß eine Aufbereitungseinrichtung vorgesehen, die ein digitales oder analoges Eingangssignal in ein geeignetes, digitales Modulationssignal umsetzt. Falls das Eingangssignal analog ist, weist die Aufbereitungseinrichtung vorzugsweise eine Abtastschaltung zum Digitalisieren des Eingangssignals auf. Da zum Erreichen einer hohen Modulationsqualität ferner eine hohe Aktualisierungsrate des Modulationssignals erforderlich ist, erfolgt gemäß einem ersten Aspekt der Erfindung eine Überabtastung und/oder eine Filterung und/oder eine Kurvenformung der abgetasteten Werte eines analogen Eingangssignals bzw. der Datenwerte eines digitalen Eingangssignals.

Wenn in bevorzugten Ausführungsformen die Modulationsinformationen als vorzeichenbehaftetes digitales Datenwort mit den Trägerfrequenzinformationen addiert werden, ist der relative Einfluß einer Veränderung der Modulationsinformationen pro Einheitabhängig von der jeweiligen Trägerfrequenz. Daher ist gemäß einem zweitem Aspekt der Erfindung eine Anpaßeinrichtung in der Aufbereitungseinrichtung vorgesehen, die die Modulationsinformationen in Abhängigkeit von der aktuellen Trägerfrequenz skaliert. Die Anpaßeinrichtung kann eine Multipliziereinheit oder, in einfachen Systemen, eine Skaliertabelle aufweisen. Ferner kann eine Frequenzgruppiereinrichtung vorgesehen sein, um Gruppen von benachbarten Trägerfrequenzen zu bilden, so daß weniger Speicherplatz in der Skaliertabelle benötigt wird.

In bevorzugten Ausführungsformen wird das Taktsignal der Digitalsynthese-Schaltung durch einen Frequenzteiler aus einem Oszillatorsignal des gesteuerten Oszillators abgeleitet. Die Digitalsynthese-Schaltung wird dann mit einem gegenüber dem Ausgangssignal viel niedrigeren Takt betrieben, wodurch der Stromverbrauch der Digitalsynthese-Schaltung und die an sie gestellten Anforderungen verringert werden.

Der gesteuerte Oszillator ist vorzugsweise ein spannungsgesteuerter Oszillator, der beispielsweise mit Kapazitätsdioden aufgebaut sein kann.

Ein Ausführungsbeispiel, das vom Erfinder gegenwärtig als der beste Weg zum Ausführen der Erfindung angesehen wird, und mehrere Ausführungsalternativen werden nun unter Hinweis auf die Zeichnungen genauer erläutert. Es stellen dar:

> **FIG 1** ein Blockschaltbild eines Ausführungsbeispiels der Schaltung, welche die Erfindung enthält,

> **FIG 2** ein Blockschaltbild einer Digitalsynthese-Schaltung,

> **FIG 3** ein Blockschaltbild einer an eine Aufbereitungseinrichtung angeschlossenen Ansteuereinrichtung, und

> **FIG 4** ein Blockschaltbild der in **FIG 3** gezeigten Aufbereitungseinrichtung gemäß der Erfindung.

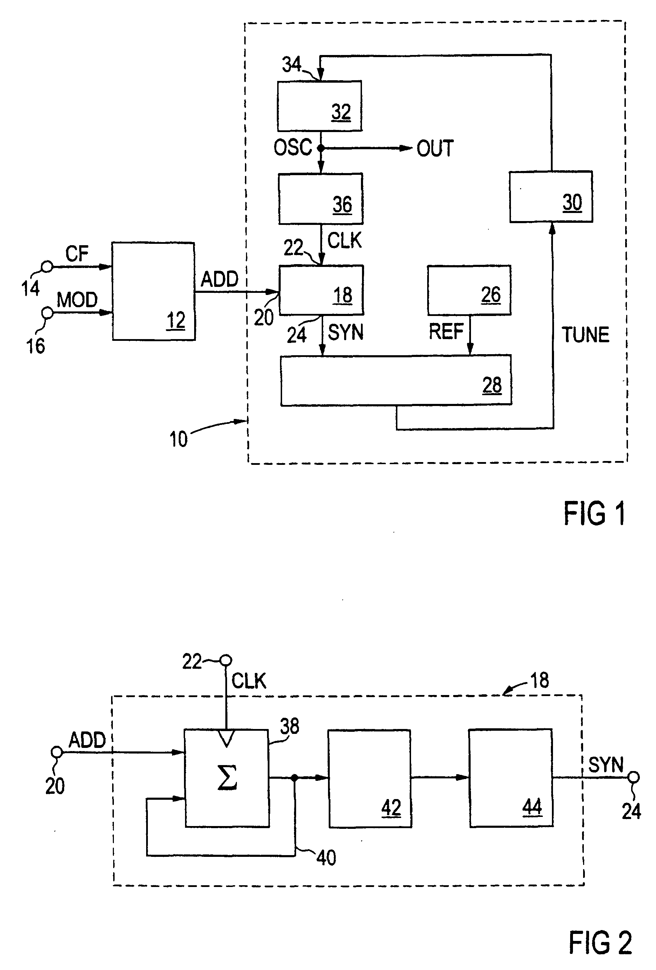

Bei der in **FIG 1** gezeigten Schaltung zum Erzeugen eines im folgenden als Ausgangssignal bezeichneten, modulierten Signals OUT wird eine reziproke Digitalsynthese-Einrichtung 10 von einer Ansteuereinrichtung 12 mit einem digitalen Ansteuersignal ADD versorgt. Die Ansteuereinrichtung 12 weist ihrerseits einen Eingang 14 für ein Trägerfrequenzsignal CF und einen Eingang 16 für ein Modulationssignal MOD auf. Jedes der Signale ADD, CF und MOD ist aus einem Bündel von Teilsignalen gebildet, die je einem Datenbit entsprechen und auf parallelen Leitungen übertragen werden.

Die reziproke Digitalsynthese-Einrichtung 10 weist als wichtige Komponente eine an sich bekannte Digitalsynthese-Schaltung 18 auf, deren Funktion später noch genauer beschrieben wird. Die auch als DDS-Schaltung (DDS = direct digital synthesizing) bezeichnete Digitalsynthese-Schaltung 18 ist beispielsweise in dem unter der Typenbezeichnung AD7008 vertriebenen Baustein der Firma Analog Devices enthalten. Das digitale Ansteuersignal ADD der Ansteuereinrichtung 12 liegt an einem Addierwerteingang 20 der Digitalsynthese-Schaltung 18 an. Ferner weist die Digitalsynthese-Schaltung 18 einen Takteingang 22 sowie einen Ausgang 24 für ein Synthesesignal SYN auf.

Ein Referenzoszillator 26 ist als Quarzoszillator ausgebildet und gibt ein Referenzsignal REF mit einer konstanten Frequenz aus. Das Referenzsignal REF und das Synthesesignal SYN liegen an Eingängen eines Phasenvergleichers 28 an. Der Phasenvergleicher 28 vergleicht die Phasenlagen der beiden Signale SYN und REF und erzeugt ein analoges Abstimmsignal TUNE, das das Ergebnis des Vergleichs wiedergibt. Das Abstimmsignal TUNE des Phasenvergleichers 28 liegt über einen Tiefpaß 30 an einem Steuereingang 34 eines spannungsgesteuerten Oszillators 32 an.

Der spannungsgesteuerte Oszillator 32 erzeugt ein sinusförmiges Oszillatorsignal OSC, das einerseits als moduliertes Ausgangssignal OUT der gesamten Schaltung dient und andererseits einer Taktformschaltung 36 zugeführt wird. Das Ausgangssignal OUT kann beispielsweise eine Frequenz von 900 MHz aufweisen und unmittelbar an eine Sendeendstufe eines Mobiltelefons geleitet werden.

Die Taktformschaltung 36 ist als begrenzender Verstärker ausgebildet und erzeugt aus dem Oszillatorsignal OSC ein rechteckförmiges Taktsignal CLK, das am Takteingang 22 der Digitalsynthese-Schaltung 18 anliegt. In Ausführungsalternativen kann das Oszillatorsignal OSC unmittelbar als Taktsignal CLK verwendet werden, so daß die Taktformschaltung 36 entfällt. Dies ist insbesondere dann möglich, wenn der Oszillator 32 ein rechteckförmiges Oszillatorsignal OSC erzeugt. In weiteren Ausführungsalternativen ist der Oszillator 32 so aufgebaut, daß er sowohl das Ausgangssignal OUT als auch das Taktsignal CLK, jeweils mit einer anderen Signalform, aber mit der gleichen Frequenz, unmittelbar erzeugt.

Insgesamt wird bei der Schaltung nach **FIG 1** der spannungsgesteuerte Oszillator 32 in der Art einer PLL-Schleife (phase locked loop) derart nachgeführt, daß die Frequenzen der Signale SYN und REF übereinstimmen. Die Digitalsynthese-Schaltung 18 wirkt dabei als fein einstellbarer Frequenzteiler, wobei über den Addierwerteingang 20 unterschiedliche, auch gebrochenzahlige Frequenzteilfaktoren einstellbar sind.

In weiteren Ausführungsalternativen der Schaltung nach **FIG 1** weist die Taktformschaltung 36 einen Frequenzteiler auf, um das Taktsignal CLK für die Digitalsynthese-Schaltung 18 aus dem Oszillatorsignal OSC mit einem festen Teilungsverhältnis abzuleiten. Auch die Frequenz des Referenzoszillators 26 ist um dieses Teilungsverhältnis niedriger. In diesen Ausführungsalternativen braucht die Digitalsynthese-Schaltung 18 nur für geringere Taktfrequenzen ausgelegt zu sein, und sie weist einen entsprechend geringeren Stromverbrauch auf.

Die Digitalsynthese-Schaltung 18 enthält, wie dies in **FIG 2** gezeigt ist, einen Akkumulator 38, also einen speichernden Summierer. Der Akkumulator 38 gibt stets den jeweils aktuellen Zählerstand aus. Durch eine Rückkopplungsverbindung 40 wird dieser Wert einem ersten Summiereingang des Akkumulators 38 zugeführt. Ein zweiter Summiereingang des Akkumulators 38 bildet den Addierwerteingang 20 der Digitalsynthese-Schaltung 18, und ein Takteingang des Akkumulators 38 bildet den Takteingang 22 der Digitalsynthese-Schaltung 18. Ferner ist eine Look-up-Tabelle 42 an den Summierwertausgang des Akkumulators 38 angeschlossen, und ein Digital/Analog-Wandler 44 erzeugt das analoge Synthesesignal SYN am Ausgang 24 je nach den Ausgaben der Look-up-Tabelle 42.

Im Betrieb addiert der Akkumulator 38 in einem durch das Taktsignal CLK bestimmten Takt den am Addierwerteingang 20 anliegenden Addierwert zu dem jeweils aktuellen Zählerstand. Der Addierbereich des Akkumulators 38 wird damit zyklisch durchlaufen, wobei eventuell auftretende Überläufe nicht berücksichtigt werden. Die Frequenz der Addierbereichsdurchläufe ist proportional zur Taktfrequenz $f_{CLK}$ und dem anliegenden Addierwert sowie umgekehrt proportional zu der Wortbreite des Akkumulators 38.

Die Look-up-Tabelle 42 transformiert die digitalen Ausgabewerte des Akkumulators 38 in eine gewünschte, zyklische Wertverlaufsfolge, aus der das analoge Synthesesignal SYN von dem Digital/Analog-Wandler 44 erzeugt wird. Durch eine geeignete Belegung der Look-up-Tabelle 42 läßt sich aus den Ausgaben des Akkumulators 38 jede periodische Signalform des Synthesesignals SYN erzeugen, im Regelfall ein sinusförmiges Signal.

In einer Ausführungsalternative der Digitalsynthese-Schaltung 18 wird die Look-up-Tabelle 42 weggelassen, und der Digital/Analog-Wandler 44 erhält den Zählerstand des Akkumulators 38 unmittelbar als Eingabewert. In diesem Fall ist das Synthesesignal SYN am Ausgang 24 ein sägezahnförmiges Signal. Die Signalform des gewünschten Synthesesignals SYN hängt von den Eigenschaften des Phasenvergleichers 28 ab.

Zusammenfassend entspricht die Frequenz $f_{SYN}$ des Synthesesignals SYN der Durchlauffrequenz des Addierbereichs des Akkumulators 38. Es gilt also die folgende, oben bereits angedeutete Beziehung:

$$f_{SYN} = \frac{f_{CLK} \cdot \text{Addierwert}}{\text{Addierbereich}}$$

Durch Verändern des Addierwerts läßt sich die Frequenz des Synthesesignals SYN (und damit der Frequenzteilfaktor der Digitalsynthese-Schaltung 18) ändern. Das Umschalten der Synthesesignalfrequenz $f_{SYN}$ kann sehr schnell und zu jedem Zeitpunkt ohne Phasensprung erfolgen.

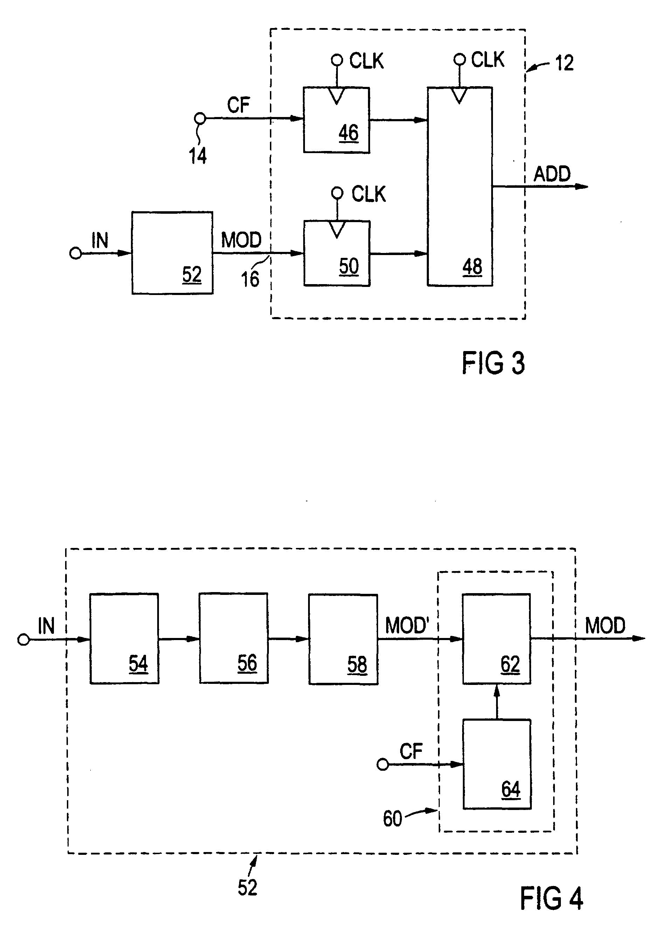

**FIG 3** zeigt den genaueren Aufbau der Ansteuereinrichtung 12. Der Eingang 14 für das Trägerfrequenzsignal CF ist über einen getakteten Zwischenspeicher 46 (latch) mit einem ersten Summiereingang eines getakteten Addierers 48 verbunden. Das an dem Eingang 16 anliegende Modulationssignal MOD ist über einen weiteren getakteten Zwischenspeicher 50 an einen zweiten Summiereingang des Addierers 48 angeschlossen. Das Ausgangssignal des Addierers 48 ist das digitale Ansteuersignal ADD, das am Addierwerteingang 20 der Digitalsynthese-Schaltung 18 anliegt.

Beim Betrieb der in **FIG 3** dargestellten Ansteuereinrichtung 12 werden die Signale CF und MOD in den Zwischenspeichern 46 und 50 gehalten und vom Addierer 48 addiert. Bei jedem Taktzyklus speichert der Zwischenspeicher 46 ein durch das Trägerfrequenzsignal CF bestimmtes digitales Datenwort, das die unmodulierte Grundfrequenz des Ausgangssignals OUT angibt.

Das Trägerfrequenzsignal CF wird in Abhängigkeit von dem gewünschten Sende-/Empfangskanal bestimmt. Zusätzlich erfolgt über das Trägerfrequenzsignal CF eine Feinabstimmung des spannungsgesteuerten Oszillators 32, um beispielsweise eine temperaturabhängige Verschiebung der Frequenz des Referenzoszillators 26 auszugleichen.

Der Zwischenspeicher 50 speichert bei jedem Taktzyklus den aktuellen Wert des aufbereiteten Modulationssignals MOD als digitales Datenwort. Dieser Wert stellt die Modulationsinformation dar und wird vom Addierer 48 als vorzeichenbehaftete Binärzahl interpretiert. Durch geeignete Variation des durch das Signal MOD definierten Modulationswerts kann die Frequenz des spannungsgesteuerten Oszillators 32 sehr schnell und genau variiert werden, so daß eine Frequenzmodulation möglich ist. Da die Phase des Ausgangssignals OUT durch das Integral von Frequenzänderungen dieses Signals bestimmt ist, kann mittels kurzzeitiger, gezielter Frequenzänderungen auch eine Phasenmodulation des Ausgangssignals OUT erfolgen.

In dem hier beschriebenen Ausführungsbeispiel werden der Addierer 48 und die beiden Zwischenspeicher 46 und 50 mit dem vom Oszillatorsignal OSC abgeleiteten Taktsignal CLK getaktet. In Ausführungsalternativen können auch andere Taktfrequenzen verwendet werden. Auf jeden Fall muß aber die Aktualisierungsrate der Modulationsinformationen erheblich größer als die Loopbandbreite der Phasenregelschleife in der reziproken Digitalsynthese-Einrichtung 10 sein. Diese Loopbandbreite wird durch die Eckfrequenz des Tiefpasses 30 bestimmt.

In **FIG 3** ist ferner eine Aufbereitungseinrichtung 52 gezeigt, die aus einem Eingangssignal IN das digitale Modulationssignal MOD erzeugt. Das Eingangssignal IN ist bei dem hier beschriebenen Ausführungsbeispiel ein analoges Signal, das die auf die Trägerfrequenz aufzumodulierenden Informationen wiedergibt.

Die Aufbereitungseinrichtung 52 des hier beschriebenen Ausführungsbeispiels ist in **FIG 4** genauer gezeigt. Das analoge Eingangssignal IN wird zunächst einer Abtastschaltung 54 zugeführt, die hier als Analog/Digital-Wandler ausgestaltet ist. In Ausführungsalternativen, bei denen das Eingangssignal IN ein digitales Signal ist, kann die Abtastschaltung 54 als getakteter Zwischenspeicher ausgebildet sein oder ganz entfallen.

Zum weiteren Aufbereiten der Modulationsinformationen ist eine Überabtastschaltung 56 vorgesehen, die weitere Abtastpunkte zwischen die von der Abtastschaltung 54 ermittelten Stützstellen des Eingangssignals IN einfügt. Die Überabtastschaltung 56 kann mittels linearer Interpolation zwischen je zwei Stützstellen arbeiten, oder sie kann mehr als zwei benachbarte Stützstellen einbeziehen und diese möglichst glatt miteinander verbinden. Zum Erzielen einer guten Modulationsqualität ist es wünschenswert, eine möglichst hohe Abtastbeziehungsweise Überabtastfrequenz zu wählen, weil die Störfrequenzanteile im Ausgangssignal OUT ansteigen, je gröber eine eventuelle Treppenstruktur im Modulationssignal MOD ist.

Um die Modulationsqualität weiter zu verbessern, ist ferner eine Filter- und Kurvenformeinrichtung 58 vorgesehen, die aus dem digitalen Ausgangssignal der Überabtastschaltung 56 ein weiter geglättetes, jedoch noch nicht skaliertes Modulations-Zwischensignal MOD' erzeugt. In Ausführungsalternativen wird das Eingangssignal IN nicht so aufwendig aufbereitet. Beispielsweise kann die Überabtastschaltung 56 oder die Filterund Kurvenformeinrichtung 58 weggelassen werden, wenn die jeweils andere Komponente schon für eine ausreichende Signalglättung sorgt. Wenn die Abtastschaltung 54 bereits mit einer hinreichend hohen Abtastfrequenz arbeitet, kann auch auf beide Komponenten 56 und 58 verzichtet werden.

Bedingt durch den Aufbau der reziproken Digitalsynthese-Einrichtung 10 ist der bei einer Veränderung des aufbereiteten Modulationssignals MOD um eine Einheit (ein LSB - least significant bit) erzeugte Modulationshub abhängig von der gegenwärtigen Trägerfrequenz. Wenn nämlich das am Addierwerteingang 20 anliegende Addierwertsignal ADD bereits einen numerisch hohen Addierwert definiert, was bei einer hohen Trägerfrequenz der Fall ist, muß die absolute Veränderung des Modulationssignals MOD entsprechend höher sein, um einen vorgegebenen Modulationshub (relativ zur Trägerfrequenz) zu erzielen.

Um diesen Effekt auszugleichen, weist die Aufbereitungseinrichtung 52 eine Anpaßeinrichtung 60 auf, die das von der Filter- und Kurvenformeinrichtung 58 erzeugte, gefilterte Modulations-Zwischensignal MOD' entsprechend der gegenwärtigen Trägerfrequenz bzw. dem gegenwärtigen Sende-/Empfangskanal skaliert.

Um diese Skalierung zu bewirken, ist in der Anpaßeinrichtung 60 ein Multiplizierer 62 vorgesehen, der das gefilterte Modulations-Zwischensignal MOD' mit einem geeigneten Skalierungsfaktor multipliziert. Der Skalierungsfaktor wird von einem Frequenzgruppierer 64 in Abhängigkeit von dem gegenwärtigen Trägerfrequenzsignal CF bestimmt. Der Frequenzgruppierer 64, der als Look-up-Tabelle ausgestaltet ist, faßt dabei mehrere benachbarte Kanäle zusammen, da sich diese in ihrer Trägerfrequenz so wenig unterscheiden, daß die Hubabweichung hier nicht ins Gewicht fällt. Wieviele Kanäle zusammengefaßt werden können, ist abhängig von der erzeugten Frequenz, dem Hub und der Kanalweite.

In Ausführungsalternativen der in **FIG 4** gezeigten Schaltung dient als Eingabewert des Frequenzgruppierers 64 nicht das Trägerfrequenzsignal CF, sondern ein anderes geeignetes Signal, das die gegenwärtige Trägerfrequenz bzw. den gegenwärtigen Sende- und Empfangskanal angibt. In weiteren Ausführungsalternativen wird auf den Frequenzgruppierer 64 verzichtet. Als ein Multiplikand des Multiplizierers 62 kann dann ein durch das aktuelle Trägerfrequenzsignal CF bestimmter Wert oder der aktuelle Addierwert oder ein aus diesen Werten abgeleiteter Wert dienen. Zum Bestimmen des Multiplikanden kann eine Look-up-Tabelle oder eine Skaliertabelle eingesetzt werden.

Die Funktion des Frequenzgruppierers 64 kann in weiteren Ausführungsalternativen besonders einfach dadurch verwirklicht werden, daß das geringstwertige Bit oder mehrere geringwertige Bits des aktuellen Trägerfrequenzsignals CF oder des aktuellen Addierwertes verworfen werden.

In insbesondere für einfachere Systeme geeigneten Ausführungsalternativen wird statt des Multiplizierers 62 eine Look-up-Tabelle eingesetzt, die in Abhängigkeit von dem Signalwert des Modulations-Zwischensignals MOD' und der von dem Frequenzgruppierer 64 bestimmten Frequenzgruppe das Modulationssignal MOD ausgibt. In diesem Fall ist der für die Look-up-Tabelle benötigte Speicherplatz um so geringer, je mehr Kanäle der Frequenzgruppierer 64 zu je einer Frequenzgruppe zusammenfaßt. Auch hier kann die Funktion des Frequenzgruppierers 64 dadurch nachgebildet werden, daß der Look-up-Tabelle nur die höherwertigen Bits des Trägerfrequenzsignals CF oder des aktuellen Addierwertes zugeführt werden.

**Patentansprüche**

1. Schaltung zum Erzeugen eines modulierten Signals (OUT), insbesondere eines frequenz- und/oder phasenmodulierten Signals, mit:

   - einem Referenzoszillator (26) zum Erzeugen eines Referenzsignals (REF),
   - einer Digitalsynthese-Schaltung (18) mit einem Takteingang (22) und einem Addierwerteingang (20) zum Erzeugen eines Synthesesignals (SYN),

- einem Phasenvergleicher (28) zum Erzeugen eines Abstimmsignals (TUNE) in Abhängigkeit von dem Ergebnis eines Vergleichs der Phase des Referenzsignals (REF) mit der Phase des Synthesesignals (SYN),

- einem in Abhängigkeit von dem Abstimmsignal (TUNE) gesteuerten Oszillator (32) zum Erzeugen des modulierten Signals (OUT) sowie eines Oszillatorsignals (OSC), aus dem ein am Takteingang (22) der Digitalsynthese-Schaltung (18) anliegendes Taktsignal (CLK) ableitbar ist, und

- einer Ansteuereinrichtung (12), die aus einem Trägerfrequenz signal und einem Modulationssignal (CF, MOD) ein digitales Ansteuersignal (ADD) erzeugt, das an dem Addierwerteingang (20) der Digitalsynthese-Schaltung (18) anliegt,

**gekennzeichnet durch**

- eine Aufbereitungseinrichtung (52) zum Erzeugen des Modulationssignals (MOD) in Abhängigkeit von einem Eingangssignal (IN), wobei die Aufbereitungseinrichtung (52) eine Abtastschaltung (54) und/oder eine Überabtastschaltung (56) und/oder eine Filtereinrichtung (58) und/oder eine Kurvenformeinrichtung (58) und

- eine Anpaßeinrichtung (60) aufweist, um das Eingangssignal (IN) oder ein von diesem abgeleitetes Signal (MOD') hinsichtlich des Modulationshubes an die jeweilige Trägerfrequenz anzupassen.

**2.** Schaltung nach Anspruch 1
**dadurch gekennzeichnet, daß** die Anpaßeinrichtung (60) einen Multiplizierer (62) und/oder eine Skaliertabelle und/oder einen Frequenzgruppierer (64) aufweist.

**3.** Schaltung nach einem der Ansprüche 1 oder 2,
**dadurch gekennzeichnet, daß** die Ansteuereinrichtung (12) einen Addierer (48) aufweist, der das Ansteuersignal (ADD) durch Addition der Trägerfrequenz- und Modulationssignale (CF, MOD) oder daraus abgeleiteter Signale erzeugt.

**4.** Schaltung nach Anspruch 3,
**dadurch gekennzeichnet, daß** die Ansteuereinrichtung (12) je einen Zwischenspeicher (46, 50) für die Trägerfrequenz- und Modulationssignale (CF, MOD) oder daraus abgeleitete Signale aufweist, und daß die beiden Zwischenspeicher (46, 50) mit Eingängen des Addierers (48) verbunden sind.

**5.** Schaltung nach einem der Ansprüche 1 bis 4,
**dadurch gekennzeichnet, daß** die Trägerfrequenz- und Modulationssignale (CF, MOD) digitale Signale sind, und daß die genannten Signale (CF, MOD) sowie das digitale Ansteuersignal (ADD) je einen Strom digitaler Datenworte definieren.

**6.** Schaltung nach einem der Ansprüche 1 bis 5,
**dadurch gekennzeichnet, daß** eine Taktformschaltung (36), insbesondere mit einem begrenzenden Verstärker und/oder einem Frequenzteiler, zum Ableiten des Taktsignals (CLK) aus dem Oszillatorsignal (OSC) vorgesehen ist.

**7.** Schaltung nach einem der Ansprüche 1 bis 6,
**dadurch gekennzeichnet, daß** das Abstimmsignal (TUNE) ein analoges Spannungssignal ist und der in Abhängigkeit von dem Abstimmsignal (TUNE) gesteuerte Oszillator (32) ein spannungsgesteuerter Oszillator ist.

**Claims**

**1.** Circuit for generating a modulated signal (OUT), in particular a frequency- and/or phase-modulated signal, having:

- a reference oscillator (26) for generating a reference signal (REF),

- a digital synthesis circuit (18) having a clock input (22) and an addition value input (20) for generating a synthesis signal (SYN),

- a phase comparator (28) for generating a tuning signal (TUNE) depending on the result of a comparison of the phase of the reference signal (REF) with the phase of the synthesis signal (SYN),

- an oscillator (32), which is controlled in a manner dependent on the tuning signal (TUNE) and serves for generating the modulated signal (OUT) and an oscillator signal (OSC), from which a clock signal (CLK) present at the clock input (22) of the digital synthesis circuit (18) can be derived, and

- a drive device (12), which generates a digital drive signal (ADD) from a carrier frequency signal and a modulation signal (CF, MOD), said drive signal being present at the addition value input (20) of the digital synthesis circuit (18),

**characterized by**

- a conditioning device (52) for generating the modulation signal (MOD) depending on an input signal (IN), the conditioning device (52) having a sampling circuit (54) and/or an oversampling circuit (56) and/or a filter device (58) and/or a waveform shaping device (58), and

- having an adapting device (60) in order to adapt the input signal (IN) or a signal (MOD') derived therefrom to the respective carrier frequency with regard to the modulation swing.

2. Circuit according to Claim 1, **characterized in that** the adapting device (60) has a multiplier (62) and/or a scaling table and/or a frequency grouper (64).

3. Circuit according to one of Claims 1 or 2, **characterized in that** the drive device (12) has an adder (48), which generates the drive signal (ADD) by addition of the carrier frequency and modulation signals (CF, MOD) or signals derived therefrom.

4. Circuit according to Claim 3, **characterized in that** the drive device (12) has a respective latch (46, 50) for the carrier frequency and modulation signals (CF, MOD) or signals derived therefrom, and **in that** the two latches (46, 50) are connected to inputs of the adder (48).

5. Circuit according to one of Claims 1 to 4, **characterized in that** the carrier frequency and modulation signals (CF, MOD) are digital signals, and **in that** the aforementioned signals (CF, MOD) and the digital drive signal (ADD) each define a stream of digital data words.

6. Circuit according to one of Claims 1 to 5, **characterized in that** provision is made of a clock shaping circuit (36), in particular having a limiting amplifier and/or a frequency divider, for deriving the clock signal (CLK) from the oscillator signal (OSC).

7. Circuit according to one of Claims 1 to 6, **characterized in that** the tuning signal (TUNE) is an analog voltage signal and the oscillator (32) controlled in a manner dependent on the tuning signal (TUNE) is a voltage-controlled oscillator.

**Revendications**

1. Circuit pour produire un signal modulé (OUT), en particulier un signal modulé en fréquence et-/-ou en phase, comprenant :

   - un oscillateur de référence (26) pour produire un signal de référence (REF),
   - un circuit de synthèse digitale (18) avec une entrée de synchronisation (22) et une entrée de valeur à additionner (20) pour produire un signal de synthèse (SYN),
   - un comparateur de phases (28) pour produire un signal de syntonisation (TUNE) en fonction du résultat d'une comparaison de la phase du signal de référence (REF) avec la phase du signal de synthèse (SYN),

   - un oscillateur (32) commandé en fonction du signal de syntonisation (TUNE) pour produire le signal modulé (OUT) ainsi qu'un signal d'oscillateur (OSC), à partir duquel peut être dérivé un signal de synchronisation (CLK) collé à l'entrée de synchronisation (22) du circuit de synthèse digitale (18), et
   - un dispositif de commande (12) qui produit un signal de commande digital (ADD) à partir d'un signal de fréquence porteuse et d'un signal de modulation (CF, MOD), lequel est adjacent à l'entrée de valeur à additionner (20) du circuit de synthèse digitale (18),

   **caractérisé par**

   - un dispositif de préparation (52) pour produire le signal de modulation (MOD) en fonction d'un signal d'entrée (IN), le dispositif de préparation (52) présentant un circuit de balayage (54) et-/-ou un circuit de surbalayage (56) et-/-ou un dispositif de filtrage (58) et-/-ou un dispositif d'allure de courbe (58) et
   - un dispositif d'adaptation (60) pour adapter le signal d'entrée (IN) ou un signal (MOD') dérivé de celui-ci concernant l'amplitude de modulation, à la fréquence porteuse respective.

2. Circuit selon la revendication 1, **caractérisé en ce que** le dispositif d'adaptation (60) présente un dispositif multiplicateur (62) et-/-ou un tableau de cadrage et-/-ou un groupeur de fréquences (64).

3. Circuit selon l'une des revendications 1 ou 2, **caractérisé en ce que** le dispositif de commande (12) présente un dispositif additionneur (48) qui produit le signal de commande (ADD) par addition des signaux de fréquence porteuse et des signaux de modulation (CF, MOD) ou des signaux qui en sont dérivés.

4. Circuit selon la revendication 3, **caractérisé en ce que** le dispositif de commande (12) présente à chaque fois une mémoire intermédiaire (46, 50) pour les signaux de fréquence porteuse et de modulation (CF, MOD) ou les signaux en étant dérivés, et **en ce que** les deux mémoires intermédiaires (46, 50) sont reliées aux entrées du dispositif additionneur (48).

5. Circuit selon l'une des revendications 1 à 4, **caractérisé en ce que** les signaux de fréquence porteuse et de modulation (CF, MOD) sont des signaux digitaux et **en ce que** les signaux mentionnés (CF, MOD) ainsi que le signal de commande digital (ADD) définissent chacun un courant de données élémentaires digitales.

**6.** Circuit selon l'une des revendications 1 à 5, **caractérisé en ce qu'**un circuit de forme synchronisée (36), comprenant notamment un amplificateur limiteur et-/-ou un diviseur de fréquence, est prévu pour dériver le signal de synchronisation (CLK) du signal de l'oscillateur (OSC).

**7.** Circuit selon l'une des revendications 1 à 6, **caractérisé en ce que** le signal de syntonisation (TUNE) est un signal de tension analogique et l'oscillateur (32) commandé en fonction du signal de syntonisation (TUNE) est un oscillateur commandé par tension.

FIG 1

FIG 2

FIG 3

FIG 4